(19) Europäisches Patentamt

European Patent Office

Office européen des brevets

(11) **EP 3 343 744 A1**

(12) **EUROPEAN PATENT APPLICATION**

(43) Date of publication:
04.07.2018 Bulletin 2018/27

(51) Int Cl.:
*H02M 3/156* (2006.01)        *H03K 7/08* (2006.01)
*H03L 7/099* (2006.01)

(21) Application number: 17209723.0

(22) Date of filing: 21.12.2017

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD TN

(30) Priority: 03.01.2017 US 201715397409

(71) Applicant: Allegro Microsystems, LLC
Worcester, MA 01606 (US)

(72) Inventor: KESARWANI, Kapil
Bedford, New Hampshire 03110 (US)

(74) Representative: South, Nicholas Geoffrey et al
A.A. Thornton & Co.
10 Old Bailey
London EC4M 7NG (GB)

(54) **DIGITAL PWM CONTROL CIRCUIT**

(57) A control circuit includes an oscillator responsive to a control voltage to generate a clock signal having an associated frequency. A counter is responsive to the clock signal to generate a count signal and a comparator is responsive to the count signal and to a threshold signal to generate a comparison signal. The control circuit further includes a delay line comprising a plurality of series coupled delay elements, each responsive to the comparison signal and to the control voltage to generate a phase shifted signal at a respective delay line output. A latch is responsive to a selected phase shifted signal to generate a control signal having edges occurring in response to edges of a signal used to set the latch and in response to the selected phase shifted signal to reset the latch. A method for generating a control signal in a control circuit is also provided.

EP 3 343 744 A1

# Description

## FIELD

This disclosure relates generally to control circuits, and more particularly, to a digital control circuit for a converter.

## BACKGROUND

As is known, DC-DC converters, such as buck converters, boost converters, and other converter types, often use Pulse Width Modulation (PWM) circuitry and techniques to control the switching element(s) of the power stage. The PWM control can be implemented with digital and/or analog circuitry and techniques. In digital PWM control, an error voltage indicative of a difference between the converter output voltage and desired output voltage is quantized to provide a binary word. The digital error word which is indicative of the required duty cycle is converted into a PWM control signal for controlling the power stage.

## SUMMARY

Described herein are concepts, systems, circuits and techniques related to a control circuit configured to generate a control signal (e.g., a PWM waveform). The control circuit includes an oscillator and a delay line, each responsive to a same or similar control voltage. More particularly, a control circuit includes an oscillator responsive to a control voltage to generate a clock signal having an associated frequency related to a voltage level of the control voltage. The control circuit also includes a counter responsive to the clock signal to generate a count signal. A comparator is responsive to the count signal and to a threshold signal to generate a comparison signal.

Each delay element in a delay line comprising a plurality of series coupled delay elements and a corresponding plurality of delay line outputs is responsive to the comparison signal and to the control voltage to generate a phase shifted signal at a respective delay line output of the plurality of delay line outputs. A multiplexer is responsive to a select signal received at a select signal input of the multiplexer and to the delay line outputs to provide a selected phase shifted signal at an output of the multiplexer. Additionally, a latch is responsive to the selected phase shifted signal to generate a control signal having edges occurring in response to edges of a signal used to set the latch and in response to the selected phase shifted signal to reset the latch. The signal used to set the latch is associated with the count signal. In embodiments, the control signal has a sub nanosecond (ns) resolution. Additionally, in embodiments the control signal is used for digital control of DC-DC converters.

The control circuit may include one or more of the following features individually or in combination with other features. The oscillator may be provided in a phase locked loop and the voltage level of the control voltage may be controlled by a charge pump. The clock signal generated by the oscillator may be substantially locked to a reference clock signal received at an input of the phase locked loop. The voltage level of the control voltage may be adjusted such that the frequency of the clock signal is substantially equal to one system clock period for a system in which the control circuit is provided. The clock signal may be a system clock signal for the system. The voltage level of the control voltage may control a delay across the delay line. The voltage level of the control voltage may be adjusted to achieve a predetermined system clock period.

The oscillator may be a ring oscillator comprising a plurality of series coupled delay elements. The delay elements in both the ring oscillator and the delay line may comprise inverters. Each of the delay elements may comprise two inverters. The ring oscillator and the delay line may each comprise a respective number of elements (e.g., delay elements). A number of elements in the delay line may be a multiple of a number of elements in the ring oscillator. The multiple of elements in the delay line with respect to the ring oscillator may be two. A total delay across the delay line is indirectly locked.

The threshold signal may be associated with most significant bits of a duty cycle signal received at an input of the control circuit. The counter may count up to a most significant bits of a duty cycle signal received at an input of the control circuit to generate the count signal. The select signal may be associated with remaining least significant bits of a duty cycle signal received at an input of the control circuit. The control circuit may be a circuit for generating a pulse width modulated (PWM) signal for a DC-DC converter. The control circuit and the DC-DC converter may both be provided in a buck regulator.

In another aspect of the concepts described herein, a control circuit includes means for generating a clock signal having an associated frequency, the frequency related to a voltage level of a control voltage. The control circuit also includes means for generating a count signal in response to the clock signal and means for comparing the count signal to a threshold signal to generate a comparison signal. The control circuit additionally includes means for generating a plurality of phase shifted signals in response to the comparison signal, the phase shifted signals each having an associated phase shift related to the voltage level of the control voltage. The control circuit further includes means for selecting a phase shifted signal of the plurality of phase shifted signals in response to a select signal and means for generating a control signal in response to the selected phase shifted signal and to a signal associated with the count signal. The control signal has edges occurring in response to edges of the signal associated with the count signal and in response to the selected phase shifted signal.

The control circuit may include one or more of the following features individually or in combination with other features. The means for generating the clock signal may be provided in a phase locked loop and the voltage level of the control voltage may be controlled by a charge pump. The voltage level of the control voltage may be adjusted such that the frequency of the clock signal is substantially equal to one system clock period for a system in which the control circuit is provided. The means for generating the clock signal and the means for generating the plurality of phase shifted signals each comprise a respective number of elements (e.g., delay elements). A number of elements in the means for generating the plurality of phase shifted signals may be a multiple of a number of elements in the means for generating the clock signal. The multiple of elements in the means for generating the plurality of phase shifted signals with respect to the means for generating the clock signal may be two. The means for generating the plurality of phase shifted signals may be a delay line whose total delay across delay line is indirectly locked.

In a further aspect of the concepts described herein, a method for generating a control signal in a control circuit includes receiving a control voltage from a voltage source and generating a clock signal having an associated frequency, with the clock signal frequency related to a voltage level of the control voltage. The method also includes generating a count signal in response to the clock signal and comparing the count signal to a threshold signal to generate a comparison signal. The method additionally includes generating a plurality of phase shifted signals in response to the comparison signal, the phase shifted signals each having an associated phase shift related to the voltage level of the control voltage. The method further includes selecting a phase shifted signal of the plurality of phase shifted signals in response to a select signal and generating the control signal in response to the selected phase shifted signal and to a signal associated with the count signal. The control signal has edges occurring in response to edges of the signal associated with the count signal and in response to the selected phase shifted signal.

The method may include one or more of the following features either individually or in combination with other features. The method may further include adjusting the voltage level of the control voltage such that the frequency of the clock signal is substantially equal to one system clock period for a system in which the control circuit is provided. Adjusting the voltage level of the control voltage may include adjusting the voltage level to control the phase shift of the phase shifted signals.

BRIEF DESCRIPTION OF THE DRAWINGS

The foregoing features of the disclosure, as well as the disclosure itself may be more fully understood from the following detailed description of the drawings, in which:

FIG. 1 is a block diagram of a regulator circuit that includes a control circuit for generating a control signal;

FIG. 2 is a block diagram of an example prior art control circuit of the regulator circuit of FIG. 1; and

FIG. 3 is a block diagram of an example control circuit according to the disclosure.

DETAILED DESCRIPTION

The features and other details of the concepts, systems, and techniques sought to be protected herein will now be more particularly described. It will be understood that any specific embodiments described herein are shown by way of illustration and not as limitations of the disclosure and the concepts described herein. Features of the subject matter described herein can be employed in various embodiments without departing from the scope of the concepts sought to be protected. Embodiments of the present disclosure and associated advantages may be best understood by referring to the drawings, where like numerals are used for like and corresponding parts throughout the various views.

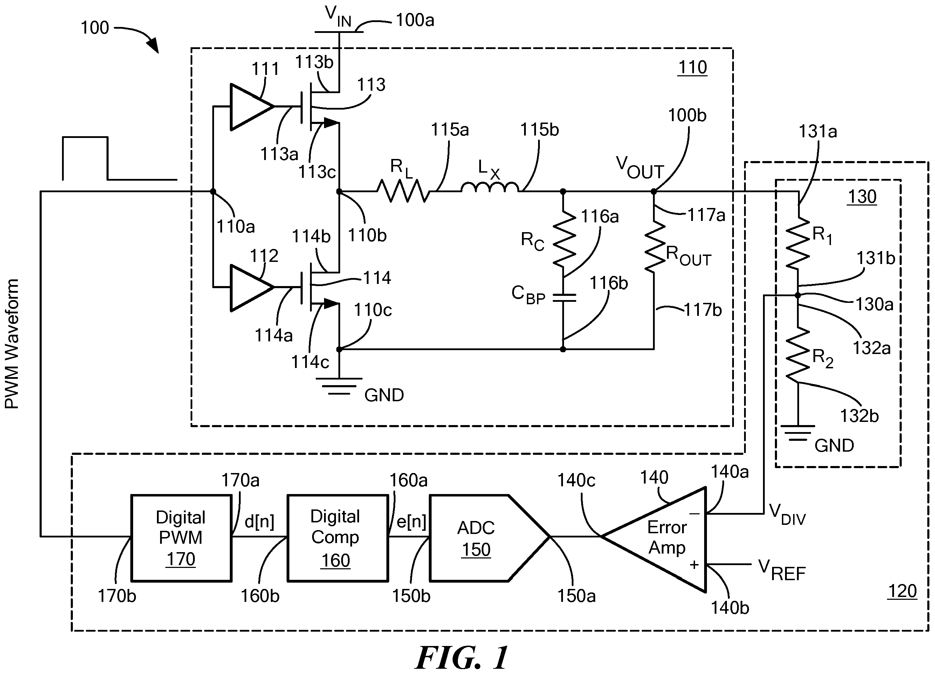

Referring now to FIG. 1, an example buck regulator circuit 100 which may be provided in a power management integrated circuit (IC), for example, includes a power stage 110 and a control circuit 120. The regulator circuit 100 has an input 100a at which an input or supply voltage $V_{IN}$ received and an output 100b at which a regulated output voltage $V_{OUT}$ (e.g., a "stepped-down" output voltage) is provided.

The power stage 110 includes a buffer 111, an inverter 112, a first transistor 113 (e.g., a first power switch) and a second transistor 114 (e.g., a second power switch). The power stage 110 also includes an output resistor $R_{out}$ and output filter (e.g., an LC filter) comprising an inductor $L_x$ and a capacitor $C_{BP}$. The inductor $L_x$ has a DC resistance $R_L$ and the capacitor $C_{BP}$ has an equivalent series resistance $R_c$, which are shown in the figure.

Transistors 113, 114 may be field effect transistors (FETs) and are provided in a push-pull configuration, each having a corresponding first terminal 113a, 114a (e.g., a gate terminal) coupled to a node 110a (here, a control node) of power stage 110 at which a control signal for controlling a voltage level of the output voltage $V_{OUT}$ is provided. The first terminals 113a, 114a are coupled to the node 110a via buffer 111 and inverter 112, respectively. Transistor 113 has a second terminal 113b (e.g., a drain terminal) coupled to regulator input 100a at which the input voltage or supply voltage $V_{IN}$ is provided and a third terminal 113c (e.g., a source terminal) coupled to a node 110b of power stage 110. Additionally, transistor 114 also has a second terminal 114b (e.g., a source terminal) coupled to node 110b and a third terminal 114c (e.g., a drain terminal) coupled to a node 110c of power stage 110, which node is coupled to a reference potential (here, GND).

Inductor $L_x$ has a first terminal 115a coupled to the node 110b and a second terminal 115b coupled to output node 100b of power stage 110. Additionally, capacitor $C_{BP}$ has a first terminal 116a coupled to output node 100b and a second terminal coupled to node 110c of power stage 110, which node is coupled to GND. Output resistor $R_{out}$ is coupled between output voltage $V_{OUT}$ node 100b and GND node 110c.

The control circuit 120 (e.g., a voltage mode control circuit), which generates the control signal received at node 110a of the power stage 110, as will be discussed further below, includes a divider circuit 130, an error amplifier 140 and an analog-to-digital converter (ADC) 150. The control circuit 120 also includes a compensator 160 and a digital PWM (DPWM) circuit 170. The divider circuit 130 includes a first resistor R1 and a second resistor R2. Resistor R1 has a first terminal 131a coupled to regulator output 100b and a second terminal 131b coupled to a node 130a (i.e., an intermediate node) of the divider circuit 130 at which a divided voltage $V_{DIV}$ is provided. Additionally, resistor R2 has a first terminal 132a coupled to node 130a and a second terminal 132b coupled to a reference potential (here, GND). Resistance values of the resistors R1, R2 may be selected to achieve a desired output voltage $V_{OUT}$, which output voltage $V_{OUT}$ is controlled by the control circuit 120.

The error amplifier 140 is coupled to receive the divided voltage $V_{DIV}$ at a first input 140a (e.g., an inverting input) and a reference voltage $V_{REF}$ at a second input 140b (e.g., a non-inverting input) and is configured to generate an error voltage at an output 140c in response to a difference between the first amplifier input 140a and the second amplifier input 140b. The ADC 150 is coupled to receive the error voltage at an ADC input 150a and is configured to generate a converted digital signal (e.g., a binary word) e[n] at an ADC output 150b in response to the ADC input 150a.

The compensator 160 (e.g., a digital compensator) is coupled to receive the converted digital signal e[n] at a compensator input 160a and is configured to generate a duty cycle word d[n] at a compensator output 160b in response to the compensator input 160a. Additionally, the DPWM circuit 170, which may be referred to herein alternatively as the DPWM control circuit or simply control circuit 170, is coupled to receive the duty cycle word d[n] at a PWM input 170a and is configured to generate a PWM, or control signal at a PWM output 170b. The control signal has a duty cycle based on the duty cycle word d[n]. Additionally, the control signal has an associated resolution (i.e., a set number of pulses that may be provided in a given pulse period) that is related to a resolution of the DPWM circuit 170 from which the control signal is generated. The resolution determines the accuracy to which the duty cycle of the converter 100 can be controlled. For example, an N-bit PWM is limited to generating a control signal having up to two to the power of n (or $2^n$) steps.

Transistors 113, 114 are each coupled to receive the control signal or an inverted version of the control signal at a corresponding input 113a, 114a and are switched on and off (i.e., between conducting and non-conducting states) in response transitions of the control signal. Transistor 113 is switched on for a first on time $t_{on1}$ in each switching period of duration $T_s$ when the control signal is at a logic high level and transistor 114 is switched on for a second on time $t_{on2}$ when the control signal is at a logic low level.

The duration of the first on time $t_{on1}$ for transistor 113 is given by $t_{on1} = D \times T_s$, where D corresponds to a duty cycle set by the control signal and $T_s$ corresponds to one complete switching period of the switching circuit comprising transistors 113, 114. Additionally, the second on time $t_{on2}$ for transistor 114 may be given by $t_{on2} = (1-D) \times T_s$ since there are only two states per switching period for continuous mode operation of the regulator circuit 100. Transistors 113, 114 both operate at a fixed switching frequency $f_s = 1/T_s$. A resolution of the output voltage $V_{OUT}$ (i.e., how finely a voltage level of the output voltage $V_{OUT}$ can be adjusted) is related to the resolution of the control signal. More particularly, the DPWM control circuit 170 used to generate the control signal has an associated resolution and a duty cycle of the control signal received by the transistors 113, 114 is based the DPWM circuit resolution. An N-bit DPWM circuit is, for example, capable representing the digital word d[n] in PWM waveform steps of $T_s/2^N$. It follows that the first and second on times $t_{on1}$, $t_{on2}$ of transistors 113, 114 can be adjusted (i.e., increased or decreased) in steps of $T_s/2^N$ using the N-bit control circuit and a voltage level of the output voltage $V_{OUT}$ may be adjusted in corresponding limited voltage steps.

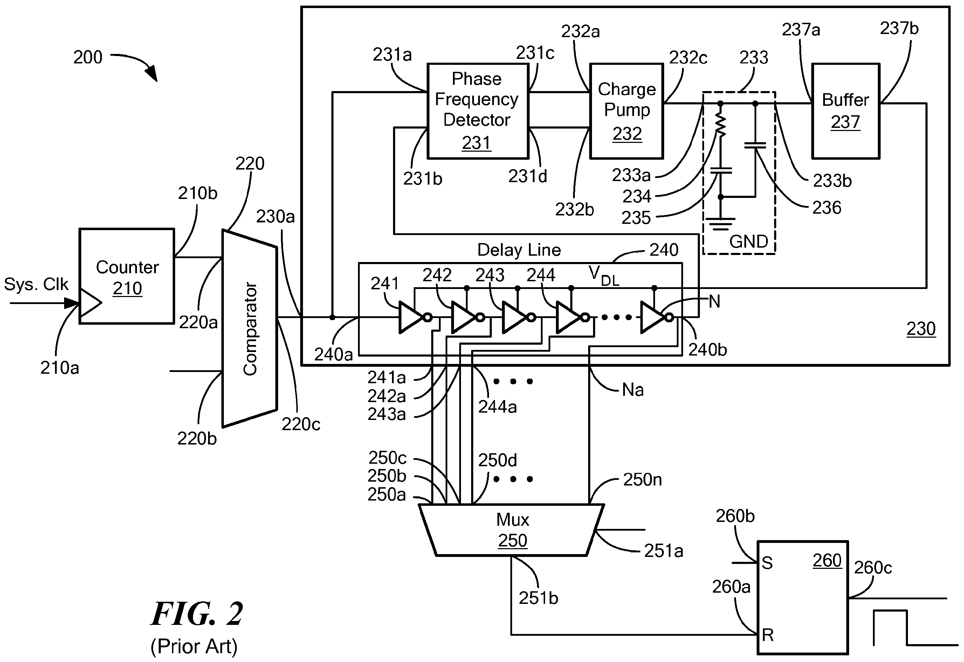

Referring now to FIG. 2, an example prior art DPWM control circuit 200 that may be provided in the regulator circuit 100 of FIG. 1 is shown. The DPWM circuit 200 includes a counter 210, a comparator 220, a delay locked loop 230, a multiplexer 250, and a latch 260 from which a control signal is generated. More particularly, the DPWM circuit 200 receives a digital duty cycle word that may be the same or similar to the duty cycle word d[n] of FIG. 1 and generates a PWM waveform at latch terminal 260c. The digital duty cycle word is provided in the form of two signals; a first signal containing the most significant bits (M) of the digital duty cycle word is coupled to comparator terminal 220b and a second signal containing the least significant bits (L) of the digital duty cycle word is coupled to multiplexer terminal 251a. Thus, the digital duty cycle word is an N bit word where N=M+L.

The counter 210 has a counter input 210a coupled to receive a clock signal at the counter input and is configured to generate a count signal at a counter output 210b in response to the clock signal. The clock signal (e.g., a system clock signal) received at counter input 210a has an associated frequency and is typically generated by an oscillator (not shown). As one example, the oscillator may be a voltage controlled oscillator (VCO) provided in a phase locked loop (PLL). The oscillator is typically responsive to a first control voltage generated by a charge pump and the frequency of the clock signal generated by the oscillator is related to a voltage level of the first control voltage. For example, the frequency of the clock signal may increase in response to a corresponding increase in the voltage level of the first control voltage. Additionally, the frequency of the clock signal may decrease in response to a corresponding decrease in the voltage level of the first control voltage.

The counter 210 may count up to most significant bits of the duty cycle signal and can thus be referred to as a most significant bit controller. The comparator 220 (e.g., a digital comparator) is coupled to receive the count signal generated by the counter 210 at a first comparator input 220a and a threshold signal in the form of the M bit duty cycle word at a second comparator input 220b and is configured to generate a comparison signal at a comparator output 220c in response to a comparison of the first comparator input 220a and the second comparator input 220b.

The delay locked loop ("DLL") 230 has a DLL input 230a coupled to the comparator output 220c and includes a phase frequency detector 231, a charge pump 232, and a buffer 237. The DLL 230 also includes a filter 233 and a delay line 240. The phase frequency detector 231 is coupled to receive the comparison signal (here, a reference signal) at a first detector input 231a and a selected phase shifted signal generated by the delay line 240 at a second detector input 231b and is configured to generate a phase error signal at detector outputs 231 c, 231 d. The phase error signal is indicative of a phase difference between the reference signal and the selected phase shifted signal. In other words, the phase error signal is indicative of whether edges of the reference signal lead or lag corresponding edges of the selected phase shifted signal.

The charge pump 232 is coupled to receive the phase error signal at charge pump inputs 232a, 232b and is configured to generate a control voltage (here, a second control voltage) at charge pump output 232c in response to the charge pump inputs 232a, 232b. A voltage level of the second control voltage is based upon a phase difference between the reference signal and the selected phase shifted signal, as indicated by the phase error signal. For example, the voltage level of the second control voltage may be increased or decreased depending upon whether edges of the reference signal lead or lag corresponding edges of the selected phase shifted signal. When the comparison signal and the reference signal are in phase (i.e., edges of the reference signal neither lead nor lag corresponding edges of the selected phase shifted signal), the voltage level the second control voltage will neither increase nor decrease (i.e., it will stay the same).

The filter 233 (e.g., a so-called "loop filter"), which comprises a resistor 234, a first capacitor 235, and a second capacitor 236, is coupled to receive the second control voltage at a filter input 233a and is configured to provide a filtered voltage at a filter output 233b in response to the filter input 233a. The second control voltage may, for example, control a voltage level of the filtered voltage through charging or discharging of capacitors 235, 236, with the filter voltage related to the phase difference between the reference signal and the selected phase shifted signal. The buffer 237 is coupled to receive the filtered voltage at a buffer input 237a and is configured to provide the filtered voltage to the delay line 240 as a delay line voltage $V_{DL}$ at a buffer output 237b. The delay line voltage $V_{DL}$ is related to the second control voltage.

The delay line 240, which comprises a plurality of series coupled inverters (here, inverters 241, 242, 243, 244, ...N) and a corresponding plurality of delay line outputs (here, outputs 241a, 242a, 243a, 244a, ...Na), has an input 240a at which the comparison signal (here, a reference signal) is received and an output 240b at which the selected phase shifted signal received by the phase frequency detector 231 is provided. Each of inverters 241, 242, 243, 244, ...N is responsive to the reference signal and to the delay line voltage $V_{DL}$ (or the second control voltage) to generate a phase shifted signal at a respective delay line output. The phase shift in the selected phase shifted signal provided at output 240b is related to a number N of inverters in the delay line 240. Additionally, the phase shift in the selected phase shifted signal is related to a voltage level of the delay line voltage $V_{DL}$.

In particular, the voltage level of the delay line voltage $V_{DL}$ is adjusted to control a total delay across the delay line 240 (e.g., a variable delay line) and, consequently, a phase shift of the selected phase shifted signal provided at output 240b is substantially in phase with the reference signal. The total delay across the delay line 240 may, for example, decrease in response to a corresponding increase in the delay line voltage $V_{DL}$. Additionally, the total delay across the delay line 240 may increase in response to a corresponding decrease in the delay line voltage $V_{DL}$. Once the selected phase shifted signal is substantially in phase with the reference signal (i.e., edges of the selected phase shifted signal line up with corresponding edges of the reference signal), the DLL 230 "locks." A resolution of the selected phase shifted signal and the PWM control signal generated at the latch output 260c may be based, at least in part, upon a number of inverters provided in the delay line 240, as will be further discussed below.

The multiplexer 250 (e.g., a L-bit MUX) has a plurality of MUX inputs 250a, 250b, 250c, 250d, ...250n coupled to respective ones of delay line outputs 241a, 242a, 243a, 244a, ...Na of the delay line 240. The MUX 250 is coupled to receive the phase shifted signals generated by each of the inverters 241, 242, 243, 244, ...N in the delay line 240 at the MUX inputs 250a, 250b, 250c, 250d, ...250n to provide a selected one of the phase shifted signals at MUX output 251b in response to a select signal input 251 a. The select signal 251 a corresponds to the least significant bits (L) of the duty cycle word d[n].

The latch 260 (e.g., a set-reset (or S-R) latch) has a first latch input 260a (e.g., a reset input) coupled to MUX output 251b, a second latch input 260b (e.g., a set input) and a latch output 260c. The latch 260 is coupled to receive the selected phase shifted signal at the first latch input 260a and a signal used to set the latch at the second latch input 260b and is configured to provide the PWM control signal at the latch output 260c. The signal used to set the latch 260 may be coupled to the counter output 210b. For example, the latch 260 may be set when the counter output 210b has a value of about zero. The PWM signal maybe received by node 110a of the buck regulator circuit 100 shown in FIG. 1 and be used to control a voltage level of the output voltage $V_{OUT}$ generated at output 100b of the buck regulator circuit 100.

The resolution of the PWM signal at the latch output 260c is related to of the design and circuit components provided in DPWM control circuit 200. For example, the resolution of the control signal may be based upon at least one of a resolution of the counter 210 and a number N of delay elements provided in delay line 240. The oscillator (not shown) used to generate the clock signal received at input 210a of counter 210 is responsive to a first control voltage generated by a first charge pump (not shown) and the delay line 240 is responsive to second control voltage generated by second charge pump (here, charge pump 232) that is different from the first charge pump. Due to non-idealities in both the first and second charge pumps, phase errors may exist in the control signal generated at the latch output 260c.

For example, since charge pumps typically comprise capacitors as energy storage elements to create a higher or lower control voltage, and the capacitors are typically charged by a first current source and discharged by a second current source that may not be matched with the first current source, control voltages generated by charge pumps will cause phase shift errors between the input signal and the output signal of a DLL/PLL (e.g., DLL 230). Non-idealities in the first charge pump in the illustrated embodiment may, for example, cause phase shift errors between the clock signal received at the counter input 210a and a reference clock signal used in generating the clock signal. Additionally, non-idealities in the second charge pump 232 may result in phase shift errors between the system clock and the clock signal generated by the delay line 240. The foregoing may prevent the total delay across delay line 240 from being equal to one system clock period. The time period error between the system clock time period and the time period of the clock generated by the DLL 230 is the principle cause of non-linearity in the prior art DPWM control circuit 200.

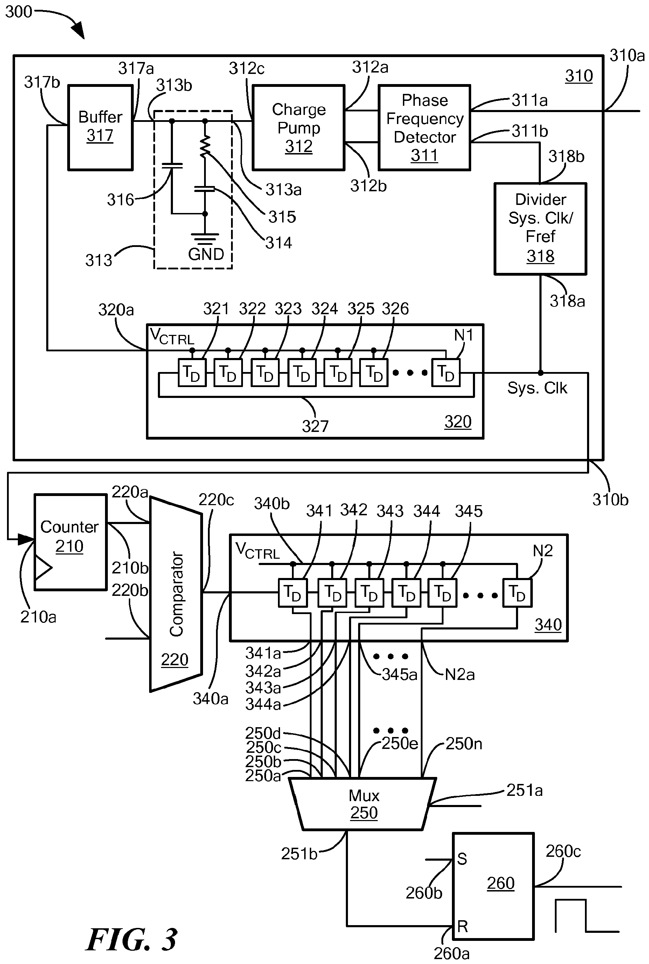

Referring to FIG. 3, in which like elements of FIG. 2 are shown having like reference designations, an example DPWM control circuit 300 according to the disclosure includes an oscillator 320, a counter 210, a comparator 220, a delay line 340, a multiplexer 250, and a latch 260 from which a PWM control signal is generated.

The oscillator 320, which is illustrative of one example configuration of an oscillator according to the disclosure, is implemented as a ring oscillator and provided in a phase locked loop (PLL) 310 in the illustrated embodiment. The oscillator 320 includes a plurality of series coupled delay elements (here, delay elements 321, 322, 323, 324, 325, 326, ...N1), with an output of a last one of the delay elements (here, N1) fed back to an input of a first one of the delay elements (here, 321) in the ring oscillator arrangement shown. The oscillator 320 has an oscillator input 320a at which a control voltage ($V_{CTRL}$) is provided and an oscillator output 320b at which a clock signal is generated.

In one embodiment, the delay elements 321, 322, 323, 324, 325, 326, ...N1 each include inverters. Additionally, in one embodiment, each of the delay elements 321, 322, 323, 324, 325, 326, ...N1 includes two inverters. Further, in one embodiment, the delay elements 321, 322, 323, 324, 325, 326, ...N1 comprise one or more voltage controlled resistors, voltage control capacitors or other voltage controlled elements. In general, the delay elements 321, 322, 323, 324, 325, ...N1 comprise elements in which a delay through the elements (or oscillator 320) may be controlled by the control voltage ($V_{CTRL}$). In some embodiments, the PLL 310, or the oscillator 320 in PLL 310, may also include a voltage controlled current source (not shown) to control a delay through the delay elements 321, 322, 323, 324, 325, 326, ...N1 or oscillator 320.

The phase locked loop 310, which is illustrative of one example configuration of a phase locked loop, includes a phase frequency detector 311, a charge pump 312, and a filter 313. The phase locked loop 310 also includes a buffer 317 and a divider 318. The PLL 310 has a PLL input 310a at which a reference clock signal is provided and a PLL output 310b at which a clock signal is generated.

The phase frequency detector 311 is coupled to receive the reference clock signal (e.g., a fixed "low" frequency signal or another signal which may be divided down using divider 318) at a first detector input 311a and a feedback signal provided by divider 318 at a second detector input 311b. The phase frequency detector 311 is configured to generate a phase error signal at detector outputs 312a, 312b in response to the first detector input 311a and the second detector input 311b. The phase error signal is indicative of a phase difference between the reference clock signal and the feedback signal. In other words, the phase error signal is indicative of whether edges of the reference clock signal lead or lag corresponding edges of the feedback signal. When the reference frequency signal and the feedback signal are substantially equal in phase and frequency, the PLL 310 is said to be in a "locked" condition.

The charge pump 312 is coupled to receive the phase error signal at charge pump inputs 312a, 312b and is configured to generate a control voltage at a charge pump output 312c in response to the charge pump inputs 312a, 312b. A voltage level of the control voltage is based upon a phase difference between the reference clock signal and the feedback signal, as indicated by the phase error signal. For example, the voltage level of the control voltage may be increased or decreased depending upon whether edges of the reference clock signal lead or lag corresponding edges of the feedback signal. When the reference clock signal and the feedback signal are in phase (i.e., PLL 310 is "locked"), the voltage level the control voltage will stay substantially the same.

The filter 313 (e.g., a so-called "loop filter"), which comprises a resistor 314, a first capacitor 315, and a second capacitor 316 in the illustrated embodiment, is coupled to receive the control voltage at a filter input 313a and is configured to provide a filtered control voltage at a filter output 313b in response to the filter input 313a. The buffer 317 is coupled to receive the filtered control voltage at a buffer input 317a and is configured to provide the filtered control voltage to oscillator 320 at a buffer output 317b.

The oscillator 320 is coupled to receive the control voltage at the oscillator input 320a and is configured to generate a clock signal at the oscillator input 320b in response to the oscillator input 320a. The clock signal has an associated frequency. The frequency of the clock signal is related to the voltage level of the control voltage. Additionally, the frequency of the clock signal is related to a number of delay elements provided in the oscillator 320 as given by the equation $f = \dfrac{1}{(2 \times t \times n)}$, where "f" corresponds to the frequency of the clock signal, "t" corresponds to a time-delay $T_D$ resulting from a single one of the delay elements in the oscillator 320, and "n" corresponds to the number of delay elements provided in the oscillator 320. In one embodiment, the clock signal is substantially locked to the reference clock signal received at input 310a of the PLL 310. In particular, the voltage level of the control voltage may be adjusted to adjust the frequency of the clock signal and to provide a feedback signal that is phase locked to the reference clock signal. In one embodiment, the voltage level of the control voltage may also be adjusted such that the frequency of the clock signal is substantially equal to one system clock period for a system in which the control circuit 300 is provided.

Once the phase locked loop 310 is "locked," the delay of each of the delay elements 321, 322, 323, 324, 325, 326, ...N1 may be represented by $T_D = t_{clk}/(2*X)$ where $t_{clk}$ corresponds to the time period of the clock signal and "X" corresponds a total number of delay elements in the oscillator 320. In one embodiment, the total number of delay elements provided in the oscillator 320 may be selected to achieve a desired resolution of the clock signal generated at the oscillator output 320b. For example, a greater number of delay elements may provide for a finer resolution clock signal.

The divider 318, which has a divide ratio of 1/N, is coupled to receive the clock signal at a divider input 318a and is configured to generate the feedback signal (here, a divided clock signal) at a divider output 318b. The feedback signal is fed back to the phase frequency detector 311, forming a closed-loop system. In one embodiment, the frequency of the clock signal generated by oscillator 320 can be adjusted by adjusting the divide ratio of the divider 318. In particular, since the feedback signal is related to the divide ratio 1/N of the divider 318 and the voltage level of the control voltage generated by the charge pump 312 is based upon a phase difference between the reference clock signal and the feedback signal, an adjustment in the divide ratio 1/N may result in a corresponding adjustment in the voltage level of the control voltage.

The counter 210 (e.g., a most significant bit (MSB) counter), which has a counter input 210a coupled to the PLL output 310b, operates in a manner similar to the counter 210 of FIG. 2 to provide a count signal at the counter output 210b. In one embodiment, the counter 210 counts up to most significant bits of a duty cycle signal (e.g., the duty cycle word d[n] generated by compensator 150 in control circuit 100 of FIG. 1) received at an input of the DPWM circuit 300 to generate the count signal. Additionally, the comparator 220, which has a first comparator input 220a coupled to the counter output 210b and a second comparator input 220b coupled to receive a threshold signal in the form of an M bit digital duty cycle word, operates in a manner similar to the comparator 220 of FIG. 2 to provide a comparison signal at the comparator output 220c. In one embodiment, the M bit digital duty cycle word corresponds to the M most significant bits of the digital duty cycle word d[n].

The delay line 340, which is illustrative of one example configuration of a delay line according to the disclosure, has a first delay line input 340a coupled to comparator output 220c and a second delay line input 340b coupled to receive the control voltage (e.g., from oscillator input 320a). The delay line 340 includes a plurality of series coupled delay elements (here, delay elements 341, 342, 343, 344, 345, ...N2). In one embodiment, the delay elements 341, 342, 343, 344, 345, ...N2 each include inverters. Additionally, in one embodiment, each of the delay elements 341, 342, 343, 344, 345, ...N2 includes two inventers.

Further, in one embodiment, the oscillator 320 and the delay line 340 each comprise a respective number delay elements and the number of delay elements in the delay line 340 is a multiple of a number of the delay elements in the oscillator 320. As one example, the multiple may be two (i.e., the oscillator 320 may have half the number of delay elements provided in the delay line 340). In one embodiment, the delay elements 341, 342, 343, 344, 345, ...N2 provided in delay line 340 are of a same type (e.g., an inverter or a voltage controlled resistor) as the delay elements 321, 322, 323, 324, 324, 326, ...N1 provided in oscillator 320.

The delay line 340 also includes a plurality of delay line outputs (here, delay line outputs 341a, 342a, 343a, 344a, 345a, ...N2a) which are coupled to respective ones of the delay elements 341, 342, 343, 344, 345, ...N2. Each of the delay elements 341, 342, 343, 344, 345, ...N2 is responsive to the comparison signal 340a and to the control voltage (i.e., a same control voltage as the control voltage to which the oscillator 320 is responsive) to generate a phase shifted signal at a respective delay line output of the plurality of delay line outputs 341a, 342a, 343a, 344a, 345a, ...N2a.

Each of the phase shifted signals has an associated phase shift related to the voltage level of the control voltage. The phase shift difference between two consecutive phase shifted signals (e.g., at delay line outputs 341a, 341b) may be substantially the same. In one embodiment, the voltage level of the control voltage controls a total delay across the delay line 340 (i.e., a delay between delay line input 340a and a delay line output associated with a last one of the delay line elements in the delay line 340, here delay line output N2a). For example, the voltage level of the control voltage may be adjusted to control a magnitude of the phase shift of the phase shifted signals and, in turn, the total delay across the delay line 340. The total delay across the delay line 340 may be selected to match the system clock period of a circuit or system in which the DPWM circuit 300 is provided. In one embodiment, the delay line 340 is a so-called "open loop delay line" and the total delay across the delay line 340 is "indirectly locked". For example, the total delay may be indirectly locked to one system clock period due to the delay line 340 being responsive to a same control voltage as the control voltage to which the oscillator 320 is responsive. The total delay may also be indirectly locked due to the oscillator 320 and the delay line 340 comprising a same type (or same types) of delay elements (e.g., inverters). Thus, indirect locking of the delay line 340 to the oscillator 320 may be achieved by controlling both with the same control voltage and/or by implementing both with the same type, number, and/or configuration of elements.

The multiplexer 250 (e.g., a L-bit MUX) has a plurality of MUX inputs 250a, 250b, 250c, 250d, 250e, ...250n coupled to respective ones of delay line outputs 341a, 342a, 343a, 344a, 345a ...N2a of the delay line 340. The MUX 250 is coupled to receive the phase shifted signals generated by each of the delay elements 341, 342, 343, 344, 345,...N2 in the delay line 340 at the MUX inputs 250a, 250b, 250c, 250d, 250e ...250n and to provide a selected one of the phase shifted signals at MUX output 251b in response to a select signal input 251a. The select signal 251a corresponds to the least significant bits (L) of the duty cycle word d[n] (FIG. 1).

The latch 260 has a first latch input 260a (e.g., a reset input) coupled to MUX output 251b, a second latch input 260b (e.g., a set input) and a latch output 260c. The latch 260 is coupled to receive the selected phase shifted signal at the first latch input 260a and a signal used to set the latch at the second latch input 260b and is configured to generate the PWM control signal 260c at the latch output 260c. The signal used to set the latch 260 is associated with the count signal. In one embodiment, the second latch input 260b is coupled to the counter output 210b. For example, the latch 260 may be set when the counter output 210b has a value of about zero.

An accurate (i.e., a high resolution) PWM control signal 260c is realized by the configuration of DPWM control circuit 300 and in particular, by way of the oscillator 320 and the delay line 340 of control circuit 300 each being responsive to a same control voltage, for example, to preserve DPWM linearity. The PWM control signal 260c may have a sub-ns (or greater) resolution. In one aspect of the disclosure, the accuracy of the DPWM control circuit 300 is substantially only limited by the accuracy to which the oscillator 320 and the delay line 340 can be matched in design, layout, and control voltage.

In one embodiment, the DPWM control circuit 300 is a circuit for generating a pulse width modulated (PWM) control signal for a DC-DC converter, such as a buck regulator.

It is to be appreciated that the DPWM control circuit 300 described above is but one of many potential configurations of control circuits in accordance with the concepts, systems, circuits and techniques described herein. As one example, while the oscillator 320 is shown and described herein provided in a phase locked loop 310, the oscillator 320 can alternatively be provided in a delay locked loop or another type of delay system or circuit.

It is also to be appreciated that while control circuits are described herein as generating control signals for controlling a voltage of regulator circuits (e.g., buck regulators), the concepts, systems, circuits and techniques sought to be protected herein are not limited to use in a particular application (e.g., regulator circuits). Rather, the control circuits may be useful in substantially any application where it is desired to have a high resolution (e.g., sub-ns resolution) control signal.

As described above and as will be appreciated by those of ordinary skill in the art, embodiments of the disclosure herein may be configured as a system, method, or combination thereof. Accordingly, embodiments of the present disclosure may be comprised of various means including hardware, software, firmware or any combination thereof.

Having described preferred embodiments, which serve to illustrate various concepts, structures and techniques, which are the subject of this patent, it will now become apparent to those of ordinary skill in the art that other embodiments incorporating these concepts, structures and techniques may be used. Additionally, elements of different embodiments described herein may be combined to form other embodiments not specifically set forth above.

Accordingly, it is submitted that that scope of the patent should not be limited to the described embodiments but rather should be limited only by the spirit and scope of the following claims.

## Claims

1. A control circuit, comprising:

    an oscillator responsive to a control voltage to generate a clock signal having an associated frequency, wherein the frequency is related to a voltage level of the control voltage;
    a counter responsive to the clock signal to generate a count signal;
    a comparator responsive to the count signal and to a threshold signal to generate a comparison signal;
    a delay line comprising a plurality of series coupled delay elements and a corresponding plurality of delay line outputs, wherein each of the delay elements is responsive to the comparison signal and to the control voltage to generate a phase shifted signal at a respective delay line output of the plurality of delay line outputs;
    a multiplexer responsive to a select signal received at a select signal input of the multiplexer and to the delay line outputs to provide a selected phase shifted signal at an output of the multiplexer; and
    a latch responsive to the selected phase shifted signal to generate a control signal having edges occurring in response to edges of a signal used to set the latch and in response to the selected phase shifted signal to reset the latch, wherein the signal used to set the latch is associated with the count signal.

2. The circuit of claim 1, wherein the oscillator is provided in a phase locked loop and the voltage level of the control voltage is controlled by a charge pump.

3. The circuit of claim 2, wherein the clock signal generated by the oscillator is substantially locked to a reference clock signal received at an input of the phase locked loop.

4. The circuit of claim 2, wherein the voltage level of the control voltage controls a delay across the delay line.

5. The circuit of claim 4, wherein the voltage level of the control voltage is adjusted to achieve a predetermined system clock period.

6. The circuit of claim 1, wherein the oscillator is a ring oscillator comprising a plurality of series coupled delay elements.

7. The circuit of claim 6, wherein the delay elements in both the ring oscillator and the delay line comprise inverters.

8. The circuit of claim 7, wherein each of the delay elements comprises two inverters.

9. The circuit of claim 6, wherein the ring oscillator and the delay line each comprise a respective number of elements, wherein a number of the elements in the delay line is a multiple of a number of the delay elements in the ring oscillator.

10. The circuit of claim 1, wherein a total delay across the delay line is indirectly locked.

11. The circuit of claim 1, wherein the threshold signal is associated with most significant bits of a duty cycle signal received at an input of the control circuit.

12. The circuit of claim 1, wherein the counter counts up to most significant bits of a duty cycle signal received at an input of the control circuit to generate the count signal.

13. The circuit of claim 1, wherein the selected phase shifted signal is associated with remaining least significant bits of a duty cycle signal received at an input of the control circuit.

14. The control circuit of claim 1, wherein the control circuit is a circuit for generating a pulse width modulated (PWM) signal for a DC-DC converter.

15. The control circuit of claim 14, wherein the control circuit and the DC-DC converter are both provided in a buck regulator.

16. A control circuit, comprising:

    means for generating a clock signal having an associated frequency, wherein the frequency is related to a voltage level of a control voltage;
    means for generating a count signal in response to the clock signal;
    means for comparing the count signal to a threshold signal to generate a comparison signal;
    means for generating a plurality of phase shifted signals in response to the comparison signal, the phase shifted signals each having an associated phase shift related to the voltage level of the control voltage;
    means for selecting a phase shifted signal of the plurality of phase shifted signals in response to a select signal; and
    means for generating a control signal in response to the selected phase shifted signal and to a signal associated with the count signal, the control signal having edges occurring in response to edges of the signal associated with the count signal and in response to the selected phase shifted signal.

**17.** The circuit of claim 16, wherein the means for generating the clock signal is provided in a phase locked loop and the voltage level of the control voltage is controlled by a charge pump.

**18.** The circuit of claim 2 or 17, wherein the voltage level of the control voltage is adjusted such that the frequency of the clock signal is substantially equal to one system clock period for a system in which the control circuit is provided.

**19.** The circuit of claim 18, wherein the clock signal is a system clock signal for the system.

**20.** The circuit of claim 18, wherein the means for generating the clock signal and the means for generating the plurality of phase shifted signals each comprise a respective number of elements, wherein a number of the elements in the means for generating the plurality of phase shifted signals is a multiple of a number of the elements in the means for generating the clock signal.

**21.** The circuit of claim 9 or 20, wherein the multiple is two.

**22.** The circuit of claim 16, wherein the means for generating the plurality of phase shifted signals is a delay line whose total delay across delay line is indirectly locked.

**23.** A method for generating a control signal in a control circuit, comprising:

receiving a control voltage from a voltage source;
generating a clock signal having an associated frequency, wherein the frequency is related to a voltage level of the control voltage;
generating a count signal in response to the clock signal;
comparing the count signal to a threshold signal to generate a comparison signal;
generating a plurality of phase shifted signals in response to the comparison signal, the phase shifted signals each having an associated phase shift related to the voltage level of the control voltage;
selecting a phase shifted signal of the plurality of phase shifted signals in response to a select signal; and
generating the control signal in response to the selected phase shifted signal and to a signal associated with the count signal, the control signal having edges occurring in response to edges of the signal associated with the count signal and in response to the selected phase shifted signal.

**24.** The method of claim 23, further comprising adjusting the voltage level of the control voltage such that the frequency of the clock signal is substantially equal to one system clock period for a system in which the control circuit is provided.

**25.** The method of claim 23, further comprising adjusting the voltage level of the control voltage to control the phase shift of the phase shifted signals.

*FIG. 1*

**FIG. 2**

(Prior Art)

EP 3 343 744 A1

**FIG. 3**

Europäisches
Patentamt

European
Patent Office

Office européen
des brevets

# EUROPEAN SEARCH REPORT

Application Number

EP 17 20 9723

## DOCUMENTS CONSIDERED TO BE RELEVANT

| Category | Citation of document with indication, where appropriate, of relevant passages | Relevant to claim | CLASSIFICATION OF THE APPLICATION  (IPC) |
|---|---|---|---|
| X | US 2009/179681 A1 (NAKAMURA KAZUTOSHI [JP] ET AL) 16 July 2009 (2009-07-16) * paragraph [0055]; figure 1 * ----- | 1-25 | INV. H02M3/156 H03K7/08 H03L7/099 |
| A | US 2009/066382 A1 (YOUSEFZADEH VAHID [US] ET AL) 12 March 2009 (2009-03-12) * paragraph [0054]; figure 5 * * paragraphs [0085] - [0089]; figure 17 * ----- | 1-25 | |
| A | EP 0 949 760 A1 (SANYO ELECTRIC CO [JP]) 13 October 1999 (1999-10-13) * the whole document * ----- | 2-10, 17-22 | |
| A | US 2008/150597 A1 (HU WEI [KR] ET AL) 26 June 2008 (2008-06-26) * paragraphs [0047] - [0071]; figure 3 * ----- | 2-10, 17-22 | |

TECHNICAL FIELDS
SEARCHED      (IPC)

H02M
H03K
H03L

The present search report has been drawn up for all claims

| Place of search | Date of completion of the search | Examiner |
|---|---|---|
| The Hague | 9 May 2018 | van Wesenbeeck, R |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

.........................................................................

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 17 20 9723

This annex lists the patent family members relating to the patent documents cited in the above-mentioned European search report.
The members are as contained in the European Patent Office EDP file on
The European Patent Office is in no way liable for these particulars which are merely given for the purpose of information.

09-05-2018

| Patent document cited in search report | | | Publication date | Patent family member(s) | | | Publication date |
|---|---|---|---|---|---|---|---|
| US 2009179681 | A1 | | 16-07-2009 | JP | 2009290857 | A | 10-12-2009 |
| | | | | US | 2009179681 | A1 | 16-07-2009 |
| | | | | US | 2011102040 | A1 | 05-05-2011 |
| | | | | US | 2011221409 | A1 | 15-09-2011 |
| | | | | US | 2012256607 | A1 | 11-10-2012 |
| | | | | US | 2013270910 | A1 | 17-10-2013 |
| | | | | US | 2014240015 | A1 | 28-08-2014 |
| US 2009066382 | A1 | | 12-03-2009 | US | 2008310200 | A1 | 18-12-2008 |
| | | | | US | 2008310201 | A1 | 18-12-2008 |
| | | | | US | 2009066382 | A1 | 12-03-2009 |
| EP 0949760 | A1 | | 13-10-1999 | EP | 0949760 | A1 | 13-10-1999 |
| | | | | JP | H11274904 | A | 08-10-1999 |
| | | | | KR | 19990078269 | A | 25-10-1999 |
| US 2008150597 | A1 | | 26-06-2008 | KR | 100839499 | B1 | 19-06-2008 |
| | | | | US | 2008150597 | A1 | 26-06-2008 |

EPO FORM P0459

For more details about this annex : see Official Journal of the European Patent Office, No. 12/82